# EUROPEAN PATENT SPECIFICATION

(11) **EP 3 157 316 B1**
(45) Date of publication and mention of the grant of the patent: **14.07.2021**
(21) Application number: 16191599.6
(22) Date of filing: 29.09.2016
(51) Int. Cl.: H05K 7/14, H05K 7/20

(54) **CONTAINER DATA CENTER**
CONTAINERDATENZENTRUM
CENTRE DE DONNÉES DE CONTENEUR

(30) Priority: 13.10.2015 TW 104133433
(43) Date of publication of application: 19.04.2017
(73) Proprietor: Cloud Network Technology Singapore PTE. LTD., Singapore 349562 (SG)
(72) Inventor: MAO, TZE-CHERN, New Taipei City (TW); CHANG, CHIH-HUNG, New Taipei City (TW); FU, YEN-CHUN, New Taipei City (TW); CHANG, YAO-TING, New Taipei City (TW); WEI, CHAO-KE, New Taipei City (TW); CHAN, HUNG-CHOU, New Taipei (TW)
(74) Representative: CMS Cameron McKenna Nabarro Olswang LLP

(56) References cited:
- EP-A1- 2 900 045
- US-A1- 2006 082 263
- US-A1- 2008 236 070
- US-A1- 2010 165 565
- US-A1- 2010 223 085
- US-A1- 2013 094 136
- US-A1- 2015 016 056
- None

## Description

### FIELD

The subject matter herein generally relates to a container data center.

### BACKGROUND

A container data center can include a container, a number of server cabinets arranged at an end of the interior of the container, and a power supply equipment group arranged at an opposite end of the interior of the container. US 20060082263 discloses a mobile data center (100) which includes a standard trailer (102), two rows of equipment racks (110A) and (110B), and two power racks (117). Each row of equipment racks (110A) and (110B) includes five general purpose equipment racks (115) along with the two power racks (117). US 20100165565 discloses a data center (10) which includes a container (12), a first longitudinal side portion (14), an opposing second longitudinal side portion (16), an electrical system (110), and a UPS (114). The electrical system (110) includes one or more power distribution panels (120A) and (120B). US 20150016056 discloses a module type data center comprising: a casing having an intake vent on one of surfaces of the casing and an exhaust vent on another one of the surfaces of the casing; a rack placed inside the casing and accommodating an electronic device; an air blower configured to introduce outside air into the casing through the intake vent and pass air through the rack from one of surfaces of the rack to another one of the surfaces of the rack; a shielding-slat unit including a plurality of shielding slats configured to change between an open state and a closed state and drive devices configured to drive the corresponding shielding slats, the shielding-slat unit being configured, to change an aperture ratio of the exhaust vent; and a controller configured to control the drive devices of the shielding-slat unit, wherein an inner space of the casing is divided into a first space defined between the one surface of the rack and the intake vent, a second space defined between the other surface of the rack and the exhaust vent, and a third space defined above the rack and allowing the second space to communicate with the first space, the data center further comprising: a temperature sensor placed inside the first space, wherein the controller controls the drive devices of the shielding-slat unit based on a signal outputted from the temperature sensor.

### BRIEF DESCRIPTION OF THE DRAWINGS

Implementations of the present technology will now be described, by way of example only, with reference to the figures.
FIG. 1 is a top plan, diagrammatic view of an embodiment of a container data center.
FIG. 2 is a side plan, diagrammatic view of the container data center of FIG. 1 in use.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiment described herein can be practiced without these specific details. In other instances, methods, procedures and components have not been described in detail so as not to obscure the related relevant feature being described. Also, the description is not to be considered as limiting the scope of the embodiments described herein. The drawings are not necessarily to scale and the proportions of certain parts have been exaggerated to better illustrate details and features of the present disclosure.

Several definitions that apply throughout this disclosure will now be presented.

The term "coupled" is defined as connected, whether directly or indirectly through intervening components, and is not necessarily limited to physical connections. The connection can be such that the objects are permanently connected or releasably connected. The term "outside" refers to a region that is beyond the outermost confines of a physical object. The term "inside" indicates that at least a portion of a region is partially contained within a boundary formed by the object. The term "comprising," when utilized, means "including, but not necessarily limited to"; it specifically indicates open-ended inclusion or membership in the so-described combination, group, series and the like.

The present disclosure described in relation to a container data center.

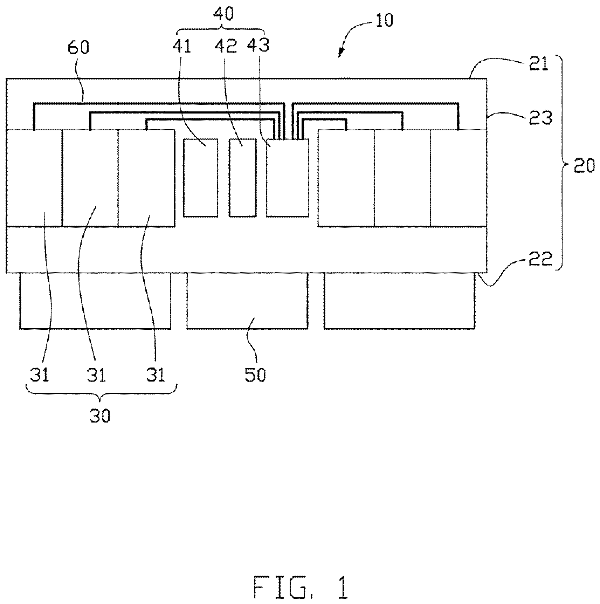

FIG. 1 illustrates an embodiment of a container data center 10. The container data center 10 comprises a container 20, two server cabinet groups 30, a power supply equipment group 40, and a plurality of air handing units 50.

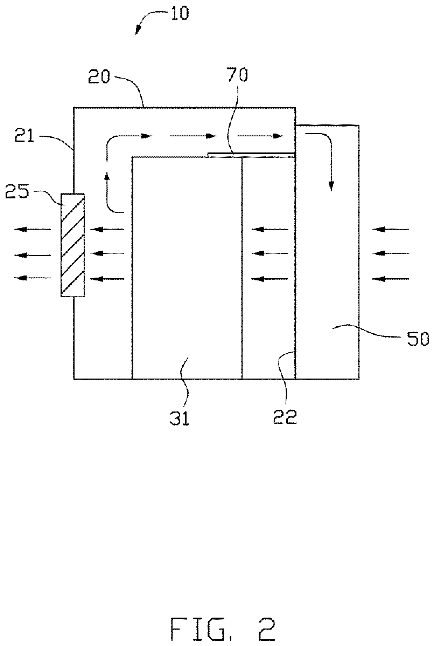

The container 20 includes a first sidewall 21, a second sidewall 22 opposite to the first sidewall 21, and two opposite end walls 23 connected between the first sidewall 21 and the second sidewall 22. A plurality of windows 25 (see FIG. 2) is horizontally aligned in the first sidewall 21.

The server cabinet groups 30 are respectively arranged at two opposite ends of the interior of the container 20. Each server cabinet group 30 comprises a plurality of spaced or adjoining server cabinets 31.

The power supply equipment group 40 is arranged in the container 20 between the two server cabinet groups 30. The power supply equipment group 40 comprises a battery cabinet 41, an UPS cabinet 42, and a power distribution cabinet 43. The battery cabinet 41, the UPS cabinet 42, and the power distribution cabinet 43 adjoin with or are spaced from each other, and adjoin with or are spaced from adjacent one of the server cabinets 31. The power supply equipment group 40 and the server cabinet groups 30 are spaced from the first sidewall 21 and the second sidewall 22, and are aligned in a line parallel to the first sidewall 21 and the second sidewall 22. A power cable 60 is coupled between the power distribution cabinet 43 and each server cabinet 31.

The air handing units 50 are mounted to an outside of the second sidewall 22, for dissipating heat and dehumidifying for the interior of the container 20. In at least one embodiment, the number of the air handing units 50 is three, the three air handing units 50 respectively align with the power supply equipment group 40 and the two server cabinet groups 30. A stop plate 70 is coupled between the second sidewall 22 and tops of the power supply equipment group 40 and the server cabinet groups 30, for isolating hot air from cool air.

During operation of the container data center 10, when air temperature outside of the container 20 is high, the windows 25 are closed. A refrigeration mode of the air handing units 50 is turned on. The air handing units 50 blow cool air into the container 20 through a lower portion of the second sidewall 22. The cool air becomes hot air after heat is exchanged with the server cabinet groups 30 and the power supply equipment group 40. The hot air flows up in an interspace between the first sidewall 21, the server cabinet groups 30, and the power supply equipment group 40, and then the hot air flows into the air handing units 50 through an upper portion of the second sidewall 22 above the stop plate 70. The server cabinet groups 30 at two ends of the container 20 produce more heat than the power supply equipment group 40, the middle one of the air handing units 50 aligning with the power supply equipment group 40 can dissipate heat for the power supply equipment group 40 and the server cabinet groups 30 at two sides of the power supply equipment group 40, which make the air handing units 50 be effectively used.

FIG. 2 shows the container data center 10 in a different state. When air temperature outside of the container 20 is low and air humidity outside of the container 20 is high, the windows 25 are open. A dehumidification mode of the air handing units 50 can be turned on. Cold air outside of the container data center 10 flows into the air handing units 50 and is mixed together with the hot air flowing into the air handing units 50 from the interior of the container 20 to form cool air. The cool air flows into the container 20 through the lower portion of the second sidewall 22. The cool air becomes hot air after heat is exchanged with the server cabinet groups 30 and the power supply equipment group 40. A portion of the volume of the hot air is discharged outside through the open windows 25. The other portion of the volume of the hot air flows in the interspace between the first sidewall 21, the server cabinet groups 30, and the power supply equipment group 40. Then the hot air flows into the air handing units 50 through an upper portion of the second sidewall 22 above the stop plate 70, and is mixed together with cold air from outside of the container data center 10 to form cool air. The power supply equipment group 40 in a middle of the container 20 produces less heat than the server cabinet groups 30 at two sides of the power supply equipment group 40, the server cabinet groups 30 can provide more hot air to the middle one of the air handing units 50 to dehumidify for the cold air, which make the air handing units 50 be effectively used.

The arrangement inside the container data center 10 is rational, and heat produced by the power supply equipment group 40 and the server cabinet groups 30 in the container data center 10 is distributed evenly, which make the air handing units 50 be effectively used. Furthermore, because the power supply equipment group 40 is arranged in the middle of the container 20, the power cables 60 connected between the power supply equipment group 40 and the server cabinets 31 are shorter than power cables in a traditional container data center, which can reduce power loss, and prevent power cables from being arranged concentratedly to block hot air backflow.

It is to be understood, however, that even though numerous characteristics and advantages of the embodiments have been set forth in the foregoing description, together with details of the structure and function of the embodiments, the disclosure is illustrative only, and changes may be made in detail, especially in the matters of shape, size, and arrangement of parts, provided that said changes fall within the scope of the invention, which is defined by the appended claims.

## Claims

1. A container data center (10), comprising:
a container (20) having an interior;
two server cabinet groups (30) respectively arranged at two opposite ends of the interior of the container (20);
a plurality of air handling units (50) mounted to an outside of the container (20); and
a power supply equipment group (40) arranged in the container (20) between the two server cabinet groups (30);
wherein the container (20) further comprises a plurality of windows (25);
wherein the container (20) comprises a first sidewall (21) and a second sidewall (22) opposite to the first sidewall (21), the power supply equipment group (40) and the server cabinet groups (30) are aligned in a line parallel to the first sidewall (21) and the second sidewall (22);
wherein the plurality of air handling units (50) are mounted to an outside of the second sidewall (22) and in communication with the interior of the container (20);
wherein the plurality of windows (25) are horizontally aligned in the first sidewall (21);
wherein when air temperature outside of the container (20) is high, a refrigeration mode of the air handling units (50) is turned on, the windows (25) are closed, the air handling units (50) blow cool air into the container (20) through a lower portion of the second sidewall (22); the cool air becomes hot air after heat is exchanged with the server cabinet groups (30) and the power supply equipment group (40); the hot air flows into the air handling units (50) through an upper portion of the second sidewall (22); when air temperature outside of the container (20) is low and air humidity outside of the container (20) is high, the windows (25) are open; a dehumidification mode of the air handling units (50) is turned on, cold air outside of the container data center (10) flows into the air handling units (50), the cold air from outside of the container data center (10) is mixed together with the hot air flowing into the air handling units (50) from the interior of the container (20) to form cool air, the cool air flows into the container (20) through the lower portion of the second sidewall (22), the cool air becomes hot air after heat is exchanged with the server cabinet groups (30) and the power supply equipment group (40); a portion of the volume of the hot air is discharged outside through the open windows (25).

2. The container data center (10) of claim 1, wherein a number of the air handling units (50) is three, and the three air handling units (50) respectively align with the power supply equipment group (40) and the two server cabinet groups (30).

3. The container data center (10) of claim 1, wherein the first sidewall (21) is spaced from the power supply equipment group (40) and the two server cabinet groups (30).

4. The container data center (10) of claim 3, wherein the second sidewall (22) is spaced from the power supply equipment group (40) and the two server cabinet groups (30), a stop plate (70) is coupled between the second sidewall (22) and the respective tops of the power supply equipment group (40) and the server cabinet groups (30), cool air in the air handling units (50) flows into the container (20) through a lower portion of the second sidewall (22) and becomes hot air after heat is exchanged with the server cabinet groups (30) and the power supply equipment group (40), at least one portion of the hot air flows up in an interspace between the first sidewall (21), the server cabinet groups (30), and the power supply equipment group (40), and into the air handling units (50) through an upper portion of the second sidewall (22) above the stop plate (70).

5. The container data center (10) of claim 1, wherein each server cabinet group (30) comprises a plurality of server cabinets (31), and a power cable (60) is coupled between each server cabinet (31) and the power supply equipment group (40).

6. The container data center (10) of claim 5, wherein the power supply equipment group (40) comprises a battery cabinet (41), a UPS cabinet (42), and a power distribution cabinet (43), the power cable (60) is coupled between each server cabinet (31) and the power distribution cabinet (43).

## Patentansprüche

1. Container-Rechenzentrum (10), das Folgendes umfasst:
einen Container (20), der ein Inneres aufweist;
zwei Serverschrankgruppen (30), die jeweils an zwei gegenüberliegenden Enden des Inneren des Containers (20) angeordnet sind;
mehrere Lüftungseinheiten (50), die an einer Außenseite des Containers (20) montiert sind; und
eine Stromversorgungsausrüstungsgruppe (40), die in dem Container (20) zwischen den zwei Serverschrankgruppen (30) angeordnet ist;
wobei der Container (20) ferner mehrere Fenster (25) umfasst;
wobei der Container (20) eine erste Seitenwand (21) und eine zweite Seitenwand (22) gegenüber der ersten Seitenwand (21) umfasst und die Stromversorgungsausrüstungsgruppe (40) und die Serverschrankgruppen (30) in einer Linie parallel zu der ersten Seitenwand (21) und der zweiten Seitenwand (22) ausgerichtet sind;
wobei die mehreren Lüftungseinheiten (50) an einer Außenseite der zweiten Seitenwand (22) montiert sind und mit dem Inneren des Containers (20) in Verbindung stehen;
wobei die mehreren Fenster (25) in der ersten Seitenwand (21) horizontal ausgerichtet sind;
wobei, wenn eine Lufttemperatur außerhalb des Containers (20) hoch ist, ein Kühlmodus der Lüftungseinheiten (50) eingeschaltet ist, die Fenster (25) geschlossen sind und die Lüftungseinheiten (50) durch einen unteren Abschnitt der zweiten Seitenwand (22) kalte Luft in den Container blasen (20); die kalte Luft zu heißer Luft wird, nachdem Wärme mit den Serverschrankgruppen (30) und der Stromversorgungsausrüstungsgruppe (40) ausgetauscht wurde; die heiße Luft durch einen oberen Abschnitt der zweiten Seitenwand (22) in die Lüftungseinheiten (50) strömt;
wenn die Lufttemperatur außerhalb des Containers (20) niedrig ist und eine Luftfeuchtigkeit außerhalb des Containers (20) hoch ist, die Fenster (25) geöffnet sind; ein Entfeuchtungsmodus der Lüftungseinheiten (50) eingeschaltet ist, kalte Luft außerhalb des Container-Rechenzentrums (10) in die Lüftungseinheiten (50) strömt, die kalte Luft von außerhalb des Container-Rechenzentrums (10) mit der heißen Luft zusammengemischt wird, die aus dem Inneren des Containers (20) in die Lüftungseinheiten (50) strömt, um kalte Luft auszubilden, die kalte Luft durch den unteren Abschnitt der zweiten Seitenwand (22) in den Container (20) strömt, die kalte Luft zu heißer Luft wird, nachdem Wärme mit den Serverschrankgruppen (30) und der Stromversorgungsausrüstungsgruppe (40) ausgetauscht wurde; ein Abschnitt des Volumens der heißen Luft durch die offenen Fenster (25) nach außen abgegeben wird.

2. Container-Rechenzentrum (10) nach Anspruch 1, wobei eine Anzahl der Lüftungseinheiten (50) drei beträgt und die drei Lüftungseinheiten (50) jeweils an der Stromversorgungsausrüstungsgruppe (40) und den zwei Serverschrankgruppen (30) ausgerichtet sind.

3. Container-Rechenzentrum (10) nach Anspruch 1, wobei die erste Seitenwand (21) von der Stromversorgungsausrüstungsgruppe (40) und den zwei Serverschrankgruppen (30) beabstandet ist.

4. Container-Rechenzentrum (10) nach Anspruch 3, wobei die zweite Seitenwand (22) von der Stromversorgungsausrüstungsgruppe (40) und den zwei Serverschrankgruppen (30) beabstandet ist, eine Anschlagplatte (70) zwischen der zweiten Seitenwand (22) und den jeweiligen Oberseiten der Stromversorgungsausrüstungsgruppe (40) und der Serverschrankgruppen (30) gekoppelt ist, kalte Luft in den Lüftungseinheiten (50) durch einen unteren Abschnitt (20) der zweiten Seitenwand (22) in den Container strömt und zu heißer Luft wird, nachdem Wärme mit den Serverschrankgruppen (30) und der Stromversorgungsausrüstungsgruppe (40) ausgetauscht wurde, wenigstens ein Abschnitt der heißen Luft in einem Zwischenraum zwischen der ersten Seitenwand (21), den Serverschrankgruppen (30) und der Stromversorgungsausrüstungsgruppe (40) und durch einen oberen Abschnitt der zweiten Seitenwand (22) über der Anschlagplatte (70) in die Lüftungseinheiten (50) hinaufströmt.

5. Container-Rechenzentrum (10) nach Anspruch 1, wobei jede Serverschrankgruppe (30) mehrere Serverschränke (31) umfasst und ein Stromkabel (60) zwischen jedem Serverschrank (31) und der Stromversorgungsausrüstungsgruppe (40) gekoppelt ist.

6. Containerrechenzentrum (10) nach Anspruch 5, wobei die Stromversorgungsausrüstungsgruppe (40) einen Batterieschrank (41), einen USV-Schrank (42) und einen Stromverteilungsschrank (43) umfasst, wobei das Stromkabel (60) zwischen jedem Serverschrank (31) und dem Stromverteilungsschrank (43) gekoppelt ist.

## Revendications

1. Centre de données de conteneur (10), comprenant :
un conteneur (20) ayant un intérieur ;
deux groupes d'armoires de serveurs (30) agencés respectivement à deux extrémités opposées de l'intérieur du conteneur (20) ;
une pluralité d'unités de traitement d'air (50) montées sur un extérieur du conteneur (20) ; et
un groupe d'équipements d'alimentation électrique (40) agencé dans le conteneur (20) entre les deux groupes d'armoires de serveurs (30) ;
dans lequel le récipient (20) comprend en outre une pluralité de fenêtres (25) ;
dans lequel le conteneur (20) comprend une première paroi latérale (21) et une seconde paroi latérale (22) opposée à la première paroi latérale (21), le groupe d'équipements d'alimentation électrique (40) et les groupes d'armoires de serveurs (30) sont alignés en ligne parallèle à la première paroi latérale (21) et à la seconde paroi latérale (22) ;
dans lequel la pluralité d'unités de traitement d'air (50) sont montées sur un extérieur de la seconde paroi latérale (22) et en communication avec l'intérieur du récipient (20) ;
dans lequel la pluralité de fenêtres (25) sont alignées horizontalement dans la première paroi latérale (21) ;
dans lequel lorsque la température de l'air à l'extérieur du récipient (20) est élevée, un mode de réfrigération des unités de traitement d'air (50) est activé, les fenêtres (25) sont fermées, les unités de traitement d'air (50) soufflent de l'air frais dans le récipient (20) à travers une partie inférieure de la seconde paroi latérale (22) ; l'air frais devient de l'air chaud après l'échange de chaleur avec les groupes d'armoires de serveurs (30) et le groupe d'équipements d'alimentation électrique (40) ; l'air chaud s'écoule dans les unités de traitement d'air (50) à travers une partie supérieure de la seconde paroi latérale (22) ; lorsque la température de l'air à l'extérieur du récipient (20) est basse et que l'humidité de l'air à l'extérieur du récipient (20) est élevée, les fenêtres (25) sont ouvertes ; un mode de déshumidification des unités de traitement d'air (50) est activé, de l'air froid à l'extérieur du centre de données de conteneurs (10) s'écoule dans les unités de traitement d'air (50), l'air froid provenant de l'extérieur du centre de données de conteneurs (10) est mélangé avec l'air chaud s'écoulant dans les unités de traitement d'air (50) depuis l'intérieur du récipient (20) pour former de l'air frais, l'air frais s'écoule dans le récipient (20) à travers la partie inférieure de la seconde paroi latérale (22), l'air frais devient de l'air chaud après l'échange de chaleur avec les groupes d'armoires de serveurs (30) et le groupe d'équipements d'alimentation électrique (40) ; une partie du volume de l'air chaud est évacuée vers l'extérieur par les fenêtres ouvertes (25).

2. Centre de données de conteneurs (10) selon la revendication 1, dans lequel un nombre d'unités de traitement d'air (50) est égal à trois, et les trois unités de traitement d'air (50) s'alignent respectivement avec le groupe d'équipements d'alimentation électrique (40) et les deux des groupes d'armoires de serveurs (30).

3. Centre de données de conteneur (10) selon la revendication 1, dans lequel la première paroi latérale (21) est espacée du groupe d'équipements d'alimentation électrique (40) et des deux groupes d'armoires de serveurs (30).

4. Centre de données à conteneurs (10) selon la revendication 3, dans lequel la seconde paroi latérale (22) est espacée du groupe d'équipements d'alimentation électrique (40) et des deux groupes d'armoires de serveurs (30), une plaque d'arrêt (70) étant accouplée entre la seconde paroi latérale (22) et les sommets respectifs du groupe d'équipements d'alimentation électrique (40) et des groupes d'armoires de serveurs (30), de l'air frais dans les unités de traitement d'air (50) s'écoulant dans le conteneur (20) à travers une partie inférieure de la seconde paroi latérale (22) et devient de l'air chaud après l'échange de chaleur avec les groupes d'armoires de serveurs (30) et le groupe d'équipements d'alimentation électrique (40), au moins une partie de l'air chaud circule dans un espace entre la première paroi latérale (21), les groupes d'armoires de serveurs (30) et le groupe d'équipements d'alimentation électrique (40), et dans les unités de traitement d'air (50) par une partie supérieure de la seconde paroi latérale (22) au-dessus de la plaque d'arrêt (70).

5. Centre de données de conteneur (10) selon la revendication 1, dans lequel chaque groupe d'armoires de serveurs (30) comprend une pluralité d'armoires de serveurs (31), et un câble d'alimentation (60) est couplé entre chaque armoire de serveurs (31) et le groupe d'alimentation électrique (40).

6. Centre de données de conteneur (10) selon la revendication 5, dans lequel le groupe d'équipements d'alimentation électrique (40) comprend une armoire de batterie (41), une armoire d'onduleur (42) et une armoire de distribution électrique (43), le câble d'alimentation (60) est couplé entre chaque armoire de serveur (31) et l'armoire de distribution électrique (43).
